# EUROPEAN PATENT APPLICATION

(11) **EP 2 262 353 A2**
(43) Date of publication of application: **15.12.2010**
(21) Application number: 10160475.9
(22) Date of filing: 20.04.2010
(51) Int. Cl.: H05K 5/02

(54) **Casing for enclosing electronic device**

(30) Priority: 20.04.2009 IN CH08992009; 22.04.2009 IN CH09362009; 29.04.2009 IN CH09982009
(71) Applicant: Moser Baer India Limited, New Delhi 110020 (IN)
(72) Inventor: Singh, Jitender Pratap, 110020, New Delhi (IN); Malhi, Vijay, 110020, New Delhi (IN)
(74) Representative: Roche, Dermot

(57) **Abstract**

A casing (102) for enclosing an electronic device (104) is provided. The electronic device (104) includes one or more electrical components and a light source (106) placed on an electronic substrate. The light source (106) is located at a periphery associated with the electronic device (104), such that light emitted from the light source (106) travels in a direction parallel to a longitudinal axis (108) of the electronic device (104). The casing (102) includes a first covering component (110) and a second covering component (112) adapted to engage together mechanically and enclose at least one section of the electronic device (104) that includes the light source (106). The second covering component (112) includes one or more reflecting surfaces (114) adapted to reflect light emitted from the light source (106) towards a pre-defined view zone (116). The reflecting surfaces (114) are inclined at one or more pre-defined angles with respect to the longitudinal axis (108) of the electronic device (104).

## Description

### CROSS-REFERENCE TO RELATED APPLICATIONS

This application claims priority from Indian Patent Application No. 998/CHE/2009 filed on April 29, 2009, Indian Patent Application No. 936/CHE/2009 filed on April 22, 2009, and Indian Patent Application No. 899/CHE/2009 filed on April 20, 2009. The entire disclosure of the prior applications is incorporated herein in their entirety by reference.

### BACKGROUND OF THE INVENTION

The present invention relates, in general, to covering mechanisms. More particularly, the present invention relates to a casing for enclosing an electronic device.

A typical Universal Serial Bus (USB) flash drive includes a light indicator that generates light indications for indicating the current state of the USB flash drive. Conventional casings for enclosing such USB flash drives are designed in a manner that a transparent portion is placed vertically above the light indicator.

In case of a USB flash drive in which a light indicator is placed horizontally, a transparent portion needs to be placed horizontally in front of the light indicator. However, since the USB flash drive generally lies horizontally when connected to a computer or a laptop, the horizontal placement of the light indicator and the transparent portion restricts view of light indication. This becomes even more problematic when the USB flash drive is very small in size and has a very small light indicator.

In light of the foregoing discussion, there is a need for a casing that allows a viewer to view light indications from a comfortable position.

### SUMMARY OF THE INVENTION

An object of the present invention is to provide a casing for enclosing an electronic device.

Another object of the present invention is to provide a casing that allows a viewer to view light indications from a comfortable position.

Embodiments of the present invention provide a casing for enclosing an electronic device. The electronic device includes one or more electrical components and a light source placed on an electronic substrate. The light source is located at a periphery associated with the electronic device, such that light emitted from the light source travels in a direction parallel to a longitudinal axis of the electronic device. The casing includes a first covering component and a second covering component. The first covering component includes one or more first portions at a first periphery associated with the first covering component. The second covering component includes one or more second portions at a second periphery associated with the second covering component. The first portions and the second portions substantially complement each other. The first portions and the second portions are capable of being engaged together mechanically to enclose at least one section of the electronic device in between the first covering component and the second covering component. The at least one section of the electronic device includes the light source. The second covering component also includes one or more reflecting surfaces adapted to reflect light emitted from the light source towards a pre-defined view zone. In accordance with an embodiment of the present invention, the pre-defined view zone is a zone through which light reflected from the reflecting surfaces is visible to a viewer.

In accordance with an embodiment of the present invention, the reflecting surfaces are inclined at one or more pre-defined angles with respect to the longitudinal axis of the electronic device. The pre-defined angles may, for example, range from 15 degrees to 50 degrees.

In accordance with an additional embodiment of the present invention, the reflecting surfaces are coated with a reflective material.

In accordance with an embodiment of the present invention, at least one of the first covering component or the second covering component includes the pre-defined view zone. The pre-defined view zone may, for example, include at least one of a hole, a transparent portion, or a translucent portion.

In accordance with an additional embodiment of the present invention, the electronic device includes one or more recessed portions at the periphery associated with the electronic device, and at least one of the first covering component or the second covering component includes one or more protruding portions at an inner periphery, such that the recessed portions and the protruding portions substantially complement each other and engage together mechanically.

In accordance with an embodiment of the present invention, the casing is made of at least one of acrylic, polyurethane, thermoplastic rubber, or plastic.

The casing allows transmission of light emitted by the light source through the pre-defined view zone, and allows a viewer to view the light from a comfortable position.

### BRIEF DESCRIPTION OF DRAWINGS

Embodiments of the present invention will hereinafter be described in conjunction with the appended drawings provided to illustrate and not to limit the scope of the claims, wherein like designations denote like elements, and in which:
FIG. 1A depicts a top view of a casing enclosing an electronic device; FIG. 1 B depicts a sectional view of a section A-A, in accordance with an embodiment of the present invention;
FIG. 2A depicts a top view of a casing enclosing an electronic device; FIG. 2B depicts a sectional view of a section B-B, in accordance with another embodiment of the present invention;
FIG. 3 depicts a system for assembling a casing, in accordance with an embodiment of the present invention;
FIG. 4 depicts a system for assembling a casing, in accordance with another embodiment of the present invention;
FIG. 5 depicts a method of assembling a casing, in accordance with an embodiment of the present invention;
FIG. 6 depicts a method of assembling a casing, in accordance with another embodiment of the present invention; and
FIG. 7 is a schematic optical diagram depicting how light rays emitted from a light source are reflected from a reflecting surface, in accordance with an exemplary embodiment of the present invention.

The same reference numerals refer to the same parts throughout the various figures.

### DETAILED DESCRIPTION

As used in the specification and claims, the singular forms "a", "an" and "the" include plural references unless the context clearly dictates otherwise. For example, the term "a light source" may include a plurality of light sources unless the context clearly dictates otherwise.

Embodiments of the present invention provide a casing for enclosing an electronic device. In the description of the embodiments of the present invention, numerous specific details are provided, such as examples of components and/or mechanisms, to provide a thorough understanding of embodiments of the present invention. One skilled in the relevant art will recognize, however, that an embodiment of the present invention can be practiced without one or more of the specific details, or with other apparatus, systems, assemblies, methods, components, materials, parts, and/or the like. In other instances, well-known structures, materials, or operations are not specifically shown or described in detail to avoid obscuring aspects of embodiments of the present invention.

### GLOSSARY

Casing: A casing encloses an electronic device, and protects the electronic device from external factors, such as heat, moisture and scratches.

First and second covering components: Covering components are capable of being engaged together mechanically to enclose at least one section of the electronic device in between.

Periphery: A periphery of a region includes a boundary of that region. In certain embodiments of the present invention, the periphery may also include a narrow area in proximity to the boundary of the region.

Reflecting surfaces: A reflecting surface is adapted to reflect light emitted from a light source towards a pre-defined view zone. The reflecting surfaces may, for example, be inclined at a pre-defined angle with respect to a longitudinal axis of the electronic device.

Reflection efficiency: The reflection efficiency of a reflecting surface is defined as the percentage of the amount of light reflected from the reflecting surface with respect to the amount of light falling on the reflecting surface.

View zone: A view zone is a zone through which light reflected from a reflecting surface is visible to a viewer. The view zone may, for example, include at least one of a hole, a transparent portion, or a translucent portion.

Hole: A hole is a three-dimensional empty region formed on a covering component through which light reflected from a reflecting surface is visible to a viewer.

Transparent portion: A transparent portion is a portion on a covering component through which light reflected from a reflecting surface is visible to a viewer. The transparent portion may, for example, be made of a transparent material, such as glass or plastic.

Translucent portion: A translucent portion is a semi-transparent portion on a covering component through which light reflected from a reflecting surface is visible to a viewer. The translucent portion may, for example, allow light to pass through diffusely.

Electronic substrate: An electronic substrate is a substrate that provides mechanical support and electrical connectivity. Examples of the electronic substrate include, but are not limited to, Printed Circuit Boards (PCBs), hybrid microcircuits, and extended PCBs. An extended PCB is a PCB including one or more conductive strips capable of facilitating a Universal Serial Bus (USB) connection.

Electrical component: An electrical component is a component of an electronic device, and is placed on appropriate slots on an electronic substrate to achieve the objective of the electronic device.

Light Source: A light source is a source of light. An example of the light source is a Light-Emitting Diode (LED). A light source may, for example, be used to indicate a current state of an electronic device, in accordance with an embodiment of the present invention.

Molding material: A molding material is a material that may be molded in any desired form. The molding material may, for example, include epoxy resin.

Flash drive: A flash drive is a storage device. At least one electrical component of the flash drive is capable of storing data.

Chip-On-Board (COB) type device: A COB type device is an electronic device manufactured by a COB process. A COB process includes directly placing a bare semiconductor die on an electronic substrate, and electrically connecting the bare semiconductor die to appropriate bond pads on the electronic substrate.

Surface Mount Technology (SMT) type device: An SMT type device is an electronic device manufactured by an SMT process. An SMT process includes mounting an Integrated Circuit (IC) on an electronic substrate.

In accordance with an embodiment of the present invention, a casing for enclosing an electronic device is provided. The electronic device includes one or more electrical components and a light source placed on an electronic substrate. The light source is located at a periphery associated with the electronic device, such that light emitted from the light source travels in a direction parallel to a longitudinal axis of the electronic device. The casing includes a first covering component and a second covering component. The first covering component includes one or more first portions at a first periphery associated with the first covering component. The second covering component includes one or more second portions at a second periphery associated with the second covering component. The first portions and the second portions substantially complement each other. The first portions and the second portions are capable of being engaged together mechanically to enclose at least one section of the electronic device in between the first covering component and the second covering component. The at least one section of the electronic device includes the light source. The second covering component also includes one or more reflecting surfaces adapted to reflect light emitted from the light source towards a pre-defined view zone. In accordance with an embodiment of the present invention, the pre-defined view zone is a zone through which light reflected from the reflecting surfaces is visible to a viewer.

In accordance with an embodiment of the present invention, the reflecting surfaces are inclined at one or more pre-defined angles with respect to the longitudinal axis of the electronic device. The pre-defined angles may, for example, range from 15 degrees to 50 degrees.

In accordance with an additional embodiment of the present invention, the reflecting surfaces are coated with a reflective material.

In accordance with an embodiment of the present invention, at least one of the first covering component or the second covering component includes the pre-defined view zone. The pre-defined view zone may, for example, include at least one of a hole, a transparent portion, or a translucent portion.

In accordance with an additional embodiment of the present invention, the electronic device includes one or more recessed portions at the periphery associated with the electronic device, and at least one of the first covering component or the second covering component includes one or more protruding portions at an inner periphery, such that the recessed portions and the protruding portions engage together mechanically. The shape of the recessed portions may, for example, be substantially complementary to the shape of the protruding portions.

In accordance with an embodiment of the present invention, the casing is molded in any desired shape and/or size from, for example, at least one of acrylic, polyurethane, thermoplastic rubber, or plastic.

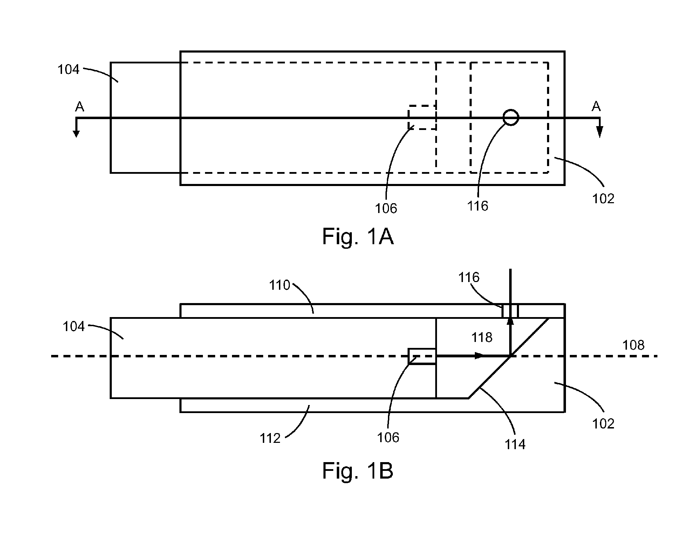

FIG. 1A depicts a top view of a casing 102 enclosing an electronic device 104; FIG. 1B depicts a sectional view of a section A-A cut through casing 102 and electronic device 104, in accordance with an embodiment of the present invention. Electronic device 104 includes one or more electrical components (not shown) and a light source 106 placed on an electronic substrate (not shown). Light source 106 is located at a periphery associated with electronic device 104, such that light emitted from light source 106 travels in a direction parallel to a longitudinal axis 108 of electronic device 104, as shown in FIG. 1B. Casing 102 includes a first covering component 110 and a second covering component 112. First covering component 110 includes one or more first portions (not shown) at a first periphery associated with first covering component 110, while second covering component 112 includes one or more second portions (not shown) at a second periphery associated with second covering component 112. The first portions and the second portions substantially complement each other, and are engaged together mechanically to enclose at least one section of electronic device 104 in between first covering component 110 and second covering component 112. The at least one section of electronic device 104 includes light source 106, as shown in FIG. 1 B.

Second covering component 112 also includes one or more reflecting surfaces, shown as a reflecting surface 114. Reflecting surface 114 is adapted to reflect light emitted from light source 106 towards a pre-defined view zone 116 through which light reflected from reflecting surface 114 is visible to a viewer, as shown in FIG. 1B. In accordance with an embodiment of the present invention, reflecting surface 114 is inclined at a pre-defined angle with respect to longitudinal axis 108 of electronic device 104. The pre-defined angle may, for example, range from 15 degrees to 50 degrees.

Reflecting surface 114 may, for example, be a smooth, polished surface. In addition, reflecting surface 114 may be coated with a reflective material to enhance the reflectivity of reflecting surface 114, in accordance with an additional embodiment of the present invention.

In a specific embodiment of the present invention, casing 102 is made of an opaque material. In such a case, reflecting surface 114 may, for example, be a smooth, polished surface of the opaque material. In such a case, the reflection efficiency of reflecting surface 114 may be approximately equal to 90 percent.

In another specific embodiment of the present invention, casing 102 is made of a translucent material. In such a case, reflecting surface 114 may, for example, be a smooth, polished surface of the translucent material. In such a case, the reflection efficiency of reflecting surface 114 may be approximately equal to 50 percent.

In accordance with an embodiment of the present invention, at least one of first covering component 110 or second covering component 112 includes pre-defined view zone 116. With reference to FIG. 1B, first covering component 110 includes pre-defined view zone 116. Pre-defined view zone 116 may, for example, include at least one of a hole, a transparent portion, or a translucent portion. A light ray 118 is reflected from reflecting surface 114 and is transmitted through pre-defined view zone 116, as shown in FIG. 1 B.

In accordance with an embodiment of the present invention, pre-defined view zone 116 is a hole covered with a transparent material, such as glass or plastic. For example, the hole may be covered with a transparent lens. The transparent lens may be coated with an anti-reflective coating, so as to avoid transmission losses due to reflection and/or total internal reflection.

In accordance with another embodiment of the present invention, first covering component 110 is made of a translucent material. In such a case, light reflected from reflecting surface 114 is visible to a viewer through a portion of first covering component 110 that acts as pre-defined view zone 116.

In accordance with an embodiment of the present invention, pre-defined view zone 116 may have a shape that is curved, polygonal, or a combination thereof. The size, the shape and/or the location of pre-defined view zone 116 may be chosen, so as to maximize the ratio of the amount of light viewed at pre-defined view zone 116 and the amount of light emitted from light source 106. Accordingly, the size and/or the shape of pre-defined view zone 116 may depend on at least one of: the size and/or shape of first covering component 110, the location of pre-defined view zone 116 on first covering component 110, or the pre-defined angle at which reflecting surface 114 is inclined, in accordance with an embodiment of the present invention.

In accordance with an embodiment of the present invention, electronic device 104 includes one or more recessed portions (not shown) at the periphery associated with electronic device 104, and at least one of first covering component 110 or second covering component 112 includes one or more protruding portions (not shown) at an inner periphery, such that the recessed portions and the protruding portions engage together mechanically. Accordingly, the shape of the recessed portions and the protruding portions may be chosen in a manner that they substantially complement each other.

Consider, for example, that a semicircular recessed portion is cut from electronic device 104. Accordingly, at least one of first covering component 110 or second covering component 112 may be molded with a semicircular protruding portion that substantially complements the semicircular recessed portion. First covering component 110 and second covering component 112 may be molded from, for example, at least one of acrylic, polyurethane, thermoplastic rubber, or plastic in any desired shape and/or size.

In accordance with an additional embodiment of the present invention, first covering component 110 and second covering component 112 are attached to electronic device 104 through a gluing process or an ultrasonic welding process.

It should be noted here that casing 102 is not limited to a specific shape or size of first covering component 110 and second covering component 112. FIGs. 1A-1 B are merely an example, which should not unduly limit the scope of the claims herein. One of ordinary skill in the art would recognize many variations, alternatives, and modifications of embodiments of the present invention.

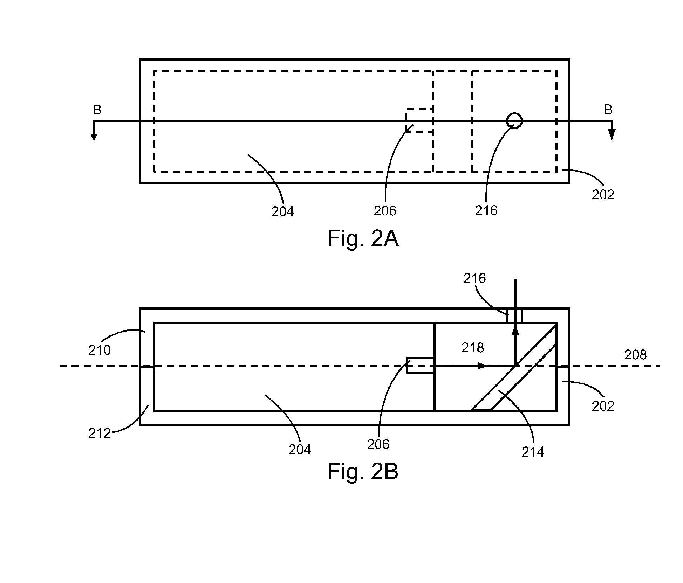

FIG. 2A depicts a top view of a casing 202 enclosing an electronic device 204; FIG. 2B depicts a sectional view of a section B-B cut through casing 202 and electronic device 204, in accordance with another embodiment of the present invention. Electronic device 204 includes one or more electrical components (not shown) and a light source 206 placed on an electronic substrate (not shown). Light source 206 is located at a periphery associated with electronic device 204, such that light emitted from light source 206 travels in a direction parallel to a longitudinal axis 208 of electronic device 204, as shown in FIG. 2B. Casing 202 includes a first covering component 210 and a second covering component 212. First covering component 210 includes one or more first portions (not shown) at a first periphery associated with first covering component 210, while second covering component 212 includes one or more second portions (not shown) at a second periphery associated with second covering component 212. The first portions and the second portions substantially complement each other, and are engaged together mechanically to enclose at least one section of electronic device 204 in between first covering component 210 and second covering component 212. The at least one section of electronic device 204 includes light source 206, as shown in FIG. 2B.

Second covering component 212 also includes one or more reflecting surfaces, shown as a reflecting surface 214. Reflecting surface 214 is adapted to reflect light emitted from light source 206 towards a pre-defined view zone 216 through which light reflected from reflecting surface 214 is visible to a viewer, as shown in FIG. 2B. In accordance with an embodiment of the present invention, reflecting surface 214 is inclined at a pre-defined angle with respect to longitudinal axis 208 of electronic device 204. The pre-defined angle may, for example, range from 15 degrees to 50 degrees.

Reflecting surface 214 may, for example, be a smooth, polished surface. In addition, reflecting surface 214 may be coated with a reflective material to enhance the reflectivity of reflecting surface 214, in accordance with an additional embodiment of the present invention.

In a specific embodiment of the present invention, casing 202 is made of an opaque material. In such a case, reflecting surface 214 may, for example, be a smooth, polished surface of the opaque material. In such a case, the reflection efficiency of reflecting surface 214 may be approximately equal to 90 percent.

In another specific embodiment of the present invention, casing 202 is made of a translucent material. In such a case, reflecting surface 214 may, for example, be a smooth, polished surface of the translucent material. In such a case, the reflection efficiency of reflecting surface 214 may be approximately equal to 50 percent.

In accordance with an embodiment of the present invention, at least one of first covering component 210 or second covering component 212 includes pre-defined view zone 216. With reference to FIG. 2B, first covering component 210 includes pre-defined view zone 216. Pre-defined view zone 216 may, for example, include at least one of a hole, a transparent portion, or a translucent portion. A light ray 218 is reflected from reflecting surface 214 and is transmitted through pre-defined view zone 216, as shown in FIG. 2B.

In accordance with an embodiment of the present invention, pre-defined view zone 216 is a hole covered with a transparent material, such as glass or plastic. For example, pre-defined view zone 216 may be covered with a transparent lens. The transparent lens may be coated with an anti-reflective coating, so as to avoid transmission losses due to reflection and/or total internal reflection.

In accordance with another embodiment of the present invention, first covering component 210 is made of a translucent material. In such a case, light reflected from reflecting surface 214 is visible to a viewer through a portion of first covering component 210 that acts as pre-defined view zone 216.

In accordance with an embodiment of the present invention, pre-defined view zone 216 may have a shape that is curved, polygonal, or a combination thereof. The size, the shape and/or the location of pre-defined view zone 216 may be chosen, so as to maximize the ratio of the amount of light viewed at pre-defined view zone 216 and the amount of light emitted from light source 206. Accordingly, the size and/or the shape of pre-defined view zone 216 may depend on at least one of: the size and/or shape of first covering component 210, the location of pre-defined view zone 216 on first covering component 210, or the pre-defined angle at which reflecting surface 214 is inclined, in accordance with an embodiment of the present invention.

In accordance with an embodiment of the present invention, electronic device 204 includes one or more recessed portions (not shown) at the periphery associated with electronic device 204, and at least one of first covering component 210 or second covering component 212 includes one or more protruding portions (not shown) at an inner periphery, such that the recessed portions and the protruding portions engage together mechanically. Accordingly, the shape of the recessed portions and the protruding portions may be chosen in a manner that they substantially complement each other.

Consider, for example, that a semicircular recessed portion is cut from electronic device 204. Accordingly, at least one of first covering component 210 or second covering component 212 may be molded with a semicircular protruding portion that substantially complements the semicircular recessed portion. First covering component 210 and second covering component 212 may be molded from, for example, at least one of acrylic, polyurethane, thermoplastic rubber, or plastic in any desired shape and/or size.

In accordance with an additional embodiment of the present invention, first covering component 210 and second covering component 212 are attached to electronic device 204 through a gluing process or an ultrasonic welding process.

It should be noted here that casing 202 is not limited to a specific shape or size of its first covering component 210 and second covering component 212. FIGs. 2A-2B are merely an example, which should not unduly limit the scope of the claims herein. One of ordinary skill in the art would recognize many variations, alternatives, and modifications of embodiments of the present invention.

An embodiment of the present invention provides a flash drive. The flash drive includes an electronic device and a casing enclosing at least one section of the electronic device. The electronic device includes an electronic substrate, one or more electrical components placed on the electronic substrate, and a light source placed on the electronic substrate. At least one of the electrical components is capable of storing data. The light source is located at a periphery associated with the electronic device. The electrical components and the light source are electrically connected in a pre-defined manner through one or more connectors. In accordance with an embodiment of the present invention, a molding material is molded over a surface of the electronic substrate on which the electrical components and the light source are placed. The molding material covers the light source partially, such that light emitted from the light source travels in a direction parallel to a longitudinal axis of the electronic device.

The casing includes a first covering component and a second covering component. The first covering component includes one or more first portions at a first periphery associated with the first covering component, while the second covering component includes one or more second portions at a second periphery associated with the second covering component. The first portions and the second portions substantially complement each other, and are engaged together mechanically to enclose the at least one section of the electronic device in between the first covering component and the second covering component. The at least one section of the electronic device includes the light source.

The second covering component also includes one or more reflecting surfaces adapted to reflect light emitted from the light source towards a pre-defined view zone through which light reflected from the reflecting surfaces is visible to a viewer. The reflecting surfaces are inclined at one or more pre-defined angles with respect to the longitudinal axis of the electronic device. The pre-defined angles may, for example, range from 15 degrees to 50 degrees.

As mentioned above, the reflecting surfaces may, for example, be smooth, polished surfaces. In addition, the reflecting surfaces may be coated with a reflective material to enhance the reflectivity of the reflecting surfaces, in accordance with an additional embodiment of the present invention.

In accordance with an embodiment of the present invention, at least one of the first covering component and the second covering component includes the pre-defined view zone. The pre-defined view zone may, for example, include at least one of: a hole, a transparent portion, and a translucent portion.

In accordance with an embodiment of the present invention, the electronic device further includes one or more recessed portions at the periphery associated with the electronic device, and at least one of the first covering component or the second covering component includes one or more protruding portions at an inner periphery, such that the recessed portions and the protruding portions engage together mechanically. The shape of the recessed portions may, for example, be substantially complementary to the shape of the protruding portions.

The casing is made from, for example, at least one of acrylic, polyurethane, thermoplastic rubber, or plastic.

In accordance with an embodiment of the present invention, the flash drive is a COB type device. In accordance with another embodiment of the present invention, the flash drive is a SMT type device.

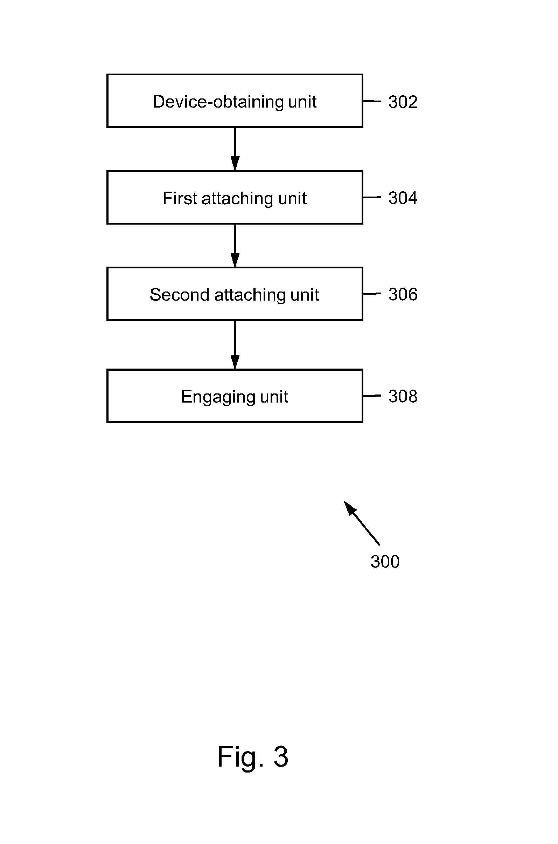

FIG. 3 depicts a system 300 for assembling a casing, in accordance with an embodiment of the present invention. System 300 includes a device-obtaining unit 302, a first attaching unit 304, a second attaching unit 306 and an engaging unit 308.

Device-obtaining unit 302 is adapted to obtain an electronic device. The electronic device includes one or more electrical components and a light source placed on an electronic substrate. The light source is located at a periphery associated with the electronic device, such that light emitted from the light source travels in a direction parallel to a longitudinal axis of the electronic device.

First attaching unit 304 is adapted to attach a first covering component to the electronic device. The first covering component includes one or more first portions at a first periphery associated with the first covering component.

Second attaching unit 306 is adapted to attach a second covering component to the electronic device. The second covering component includes one or more second portions at a second periphery associated with the second covering component. In accordance with an embodiment of the present invention, the first portions and the second portions substantially complement each other.

Engaging unit 308 is adapted to engage the first portions and the second portions together mechanically to enclose at least one section of the electronic device in between the first covering component and the second covering component. The at least one section of the electronic device includes the light source.

In accordance with an embodiment of the present invention, the second covering component includes one or more reflecting surfaces adapted to reflect light emitted from the light source towards a pre-defined view zone through which light reflected from the reflecting surfaces is visible to a viewer. In accordance with an embodiment of the present invention, the reflecting surfaces are inclined at one or more pre-defined angles with respect to the longitudinal axis of the electronic device. The pre-defined angles may, for example, range from 15 degrees to 50 degrees.

FIG. 3 is merely an example, which should not unduly limit the scope of the claims herein. One of ordinary skill in the art would recognize many variations, alternatives, and modifications of embodiments of the present invention.

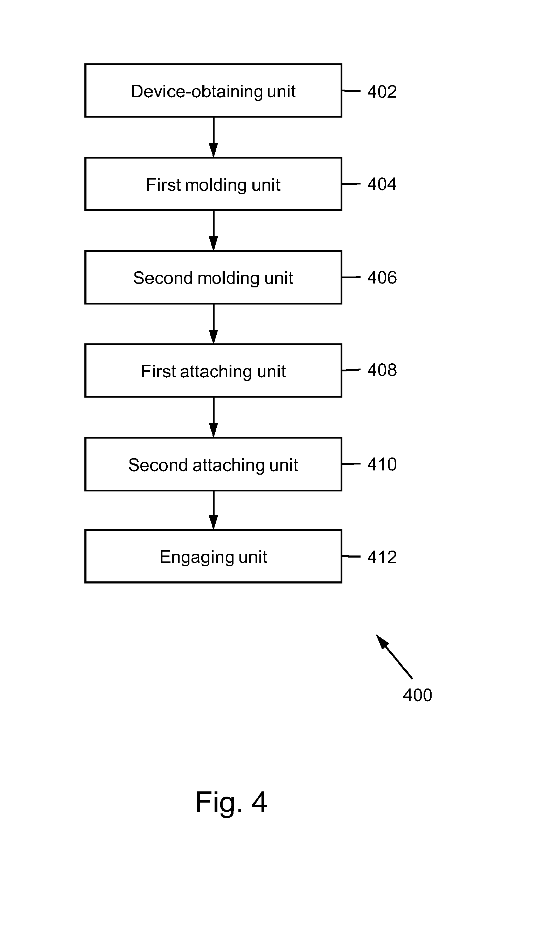

FIG. 4 depicts a system 400 for assembling a casing, in accordance with another embodiment of the present invention. System 400 includes a device-obtaining unit 402, a first molding unit 404, a second molding unit 406, a first attaching unit 408, a second attaching unit 410 and an engaging unit 412.

Device-obtaining unit 402 is adapted to obtain an electronic device. The electronic device includes one or more electrical components and a light source placed on an electronic substrate. The light source is located at a periphery associated with the electronic device, such that light emitted from the light source travels in a direction parallel to a longitudinal axis of the electronic device.

First molding unit 404 is adapted to mold a first covering component. First molding unit 404 is adapted to mold the first covering component with one or more first portions formed at a first periphery associated with the first covering component.

In addition, first molding unit 404 may be adapted to form a pre-defined view zone on the first covering component as desired, in accordance with an embodiment of the present invention. The pre-defined view zone may, for example, include at least one of a hole, a transparent portion, or a translucent portion.

Second molding unit 406 is adapted to mold a second covering component. Second molding unit 406 is adapted to mold the second covering component with one or more second portions formed at a second periphery associated with the second covering component.

In accordance with an embodiment of the present invention, the first portions and the second portions substantially complement each other. Accordingly, first molding unit 404 and second molding unit 406 are adapted to form the first portions and the second portions, such that the shape of the first portions substantially complements the shape of the second portions.

In accordance with an embodiment of the present invention, the second covering component includes one or more reflecting surfaces adapted to reflect light emitted from the light source towards the pre-defined view zone. The reflecting surfaces are inclined at one or more pre-defined angles with respect to the longitudinal axis of the electronic device, in accordance with an embodiment of the present invention. Accordingly, second molding unit 406 may be adapted to form the reflecting surfaces as desired.

In addition, system 400 may include a polishing unit adapted to polish the reflecting surface, in accordance with an embodiment of the present invention. System 400 may also include a coating unit adapted to coat the reflective surfaces with a reflective material, in accordance with an additional embodiment of the present invention.

In accordance with an embodiment of the present invention, the electronic device includes one or more recessed portions on the periphery associated with the electronic device, while the first covering component and the second covering component includes one or more protruding portions on inner peripheries associated with the first covering component and the second covering component. The recessed portions and the protruding portions substantially complement each other. First molding unit 404 and second molding unit 406 may, for example, be adapted to form the protruding portions on the first covering component and the second covering component, respectively. In addition, system 400 may include a cutting unit adapted to cut the recessed portions from the electronic device as desired.

First attaching unit 408 is adapted to attach the first covering component to the electronic device, while second attaching unit 410 is adapted to attach the second covering component to the electronic device. First attaching unit 408 and second attaching unit 410 may be adapted to engage the protruding portions and the recessed portions together mechanically.

Engaging unit 412 is adapted to engage the first portions and the second portions together mechanically to enclose at least one section of the electronic device in between the first covering component and the second covering component. The at least one section of the electronic device includes the light source.

FIG. 4 is merely an example, which should not unduly limit the scope of the claims herein. One of ordinary skill in the art would recognize many variations, alternatives, and modifications of embodiments of the present invention.

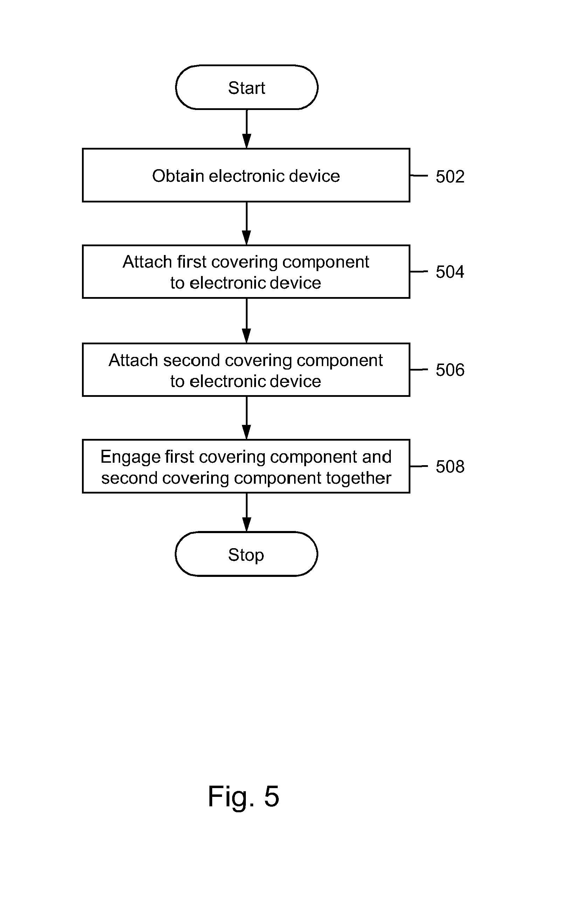

FIG. 5 depicts a method of assembling a casing, in accordance with an embodiment of the present invention. The method is illustrated as a collection of steps in a logical flow diagram, which represents a sequence of steps that can be implemented in hardware, software, or a combination thereof.

At step 502, an electronic device is obtained. The electronic device includes one or more electrical components and a light source placed on an electronic substrate. The light source is located at a periphery associated with the electronic device, such that light emitted from the light source travels in a direction parallel to a longitudinal axis of the electronic device.

At step 504, a first covering component is attached to the electronic device. The first covering component includes one or more first portions at a first periphery associated with the first covering component.

At step 506, a second covering component is attached to the electronic device. The second covering component includes one or more second portions at a second periphery associated with the second covering component. In accordance with an embodiment of the present invention, the first portions and the second portions substantially complement each other.

At step 508, the first portions and the second portions are engaged together mechanically to enclose at least one section of the electronic device in between the first covering component and the second covering component. The at least one section of the electronic device includes the light source.

In accordance with an embodiment of the present invention, the second covering component includes one or more reflecting surfaces adapted to reflect light emitted from the light source towards a pre-defined view zone through which light reflected from the reflecting surfaces is visible to a viewer. In accordance with an embodiment of the present invention, the reflecting surfaces are inclined at one or more pre-defined angles with respect to the longitudinal axis of the electronic device. The pre-defined angles may, for example, range from 15 degrees to 50 degrees.

It should be noted here that steps 502-508 are only illustrative and other alternatives can also be provided where steps are added, one or more steps are removed, or one or more steps are provided in a different sequence without departing from the scope of the claims herein.

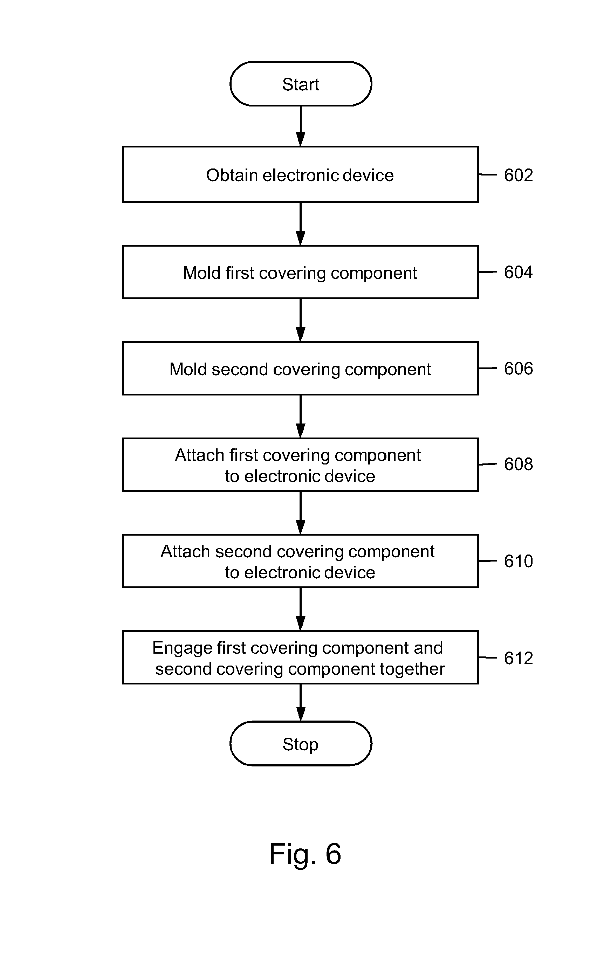

FIG. 6 depicts a method of assembling a casing, in accordance with another embodiment of the present invention. The method is illustrated as a collection of steps in a logical flow diagram, which represents a sequence of steps that can be implemented in hardware, software, or a combination thereof.

At step 602, an electronic device is obtained. The electronic device includes one or more electrical components and a light source placed on an electronic substrate. The light source is located at a periphery associated with the electronic device, such that light emitted from the light source travels in a direction parallel to a longitudinal axis of the electronic device.

At step 604, a first covering component is molded. The first covering component so molded includes one or more first portions formed at a first periphery associated with the first covering component. In addition, a pre-defined view zone may be formed on the first covering component at step 604. The pre-defined view zone may, for example, include at least one of a hole, a transparent portion, or a translucent portion.

At step 606, a second covering component is molded. The second covering component so molded includes one or more second portions formed at a second periphery associated with the second covering component.

In accordance with an embodiment of the present invention, the first portions and the second portions substantially complement each other. Accordingly, the shape of the first portions formed at step 604 substantially complements the shape of the second portions formed at step 606.

In accordance with an embodiment of the present invention, the second covering component includes one or more reflecting surfaces adapted to reflect light emitted from the light source towards the pre-defined view zone. Accordingly, the reflecting surfaces may be formed as desired at step 606.

Additionally, a step of inclining the reflecting surfaces at one or more pre-defined angles with respect to the longitudinal axis of the electronic device may be performed. The pre-defined angles range from 15 degrees to 50 degrees.

In accordance with an embodiment of the present invention, a step of polishing the reflecting surface may be performed. In accordance with an additional embodiment of the present invention, a step of coating the reflective surfaces with a reflective material may be performed.

In accordance with an embodiment of the present invention, the electronic device includes one or more recessed portions on the periphery associated with the electronic device, while the first covering component and the second covering component includes one or more protruding portions on inner peripheries associated with the first covering component and the second covering component. The recessed portions and the protruding portions substantially complement each other. Accordingly, the protruding portions on the first covering component and the second covering component may be formed at step 604 and step 606, respectively. In addition, a step of cutting the recessed portions from the electronic device may be performed.

At step 608, the first covering component is attached to the electronic device. At step 610, the second covering component is attached to the electronic device. In accordance with step 608 and step 610, the protruding portions and the recessed portions are engaged together mechanically.

At step 612, the first portions and the second portions are engaged together mechanically to enclose at least one section of the electronic device in between the first covering component and the second covering component. The at least one section of the electronic device includes the light source.

It should be noted here that steps 602-612 are only illustrative and other alternatives can also be provided where steps are added, one or more steps are removed, or one or more steps are provided in a different sequence without departing from the scope of the claims herein.

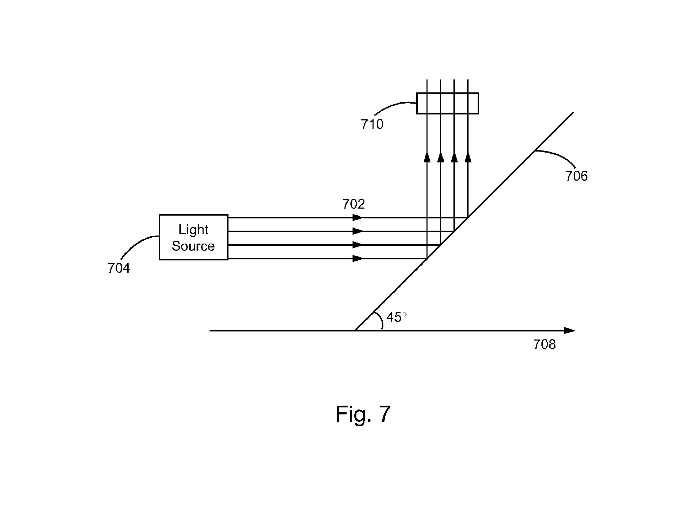

FIG. 7 is a schematic optical diagram depicting how light rays 702 emitted from a light source 704 are reflected from a reflecting surface 706, in accordance with an exemplary embodiment of the present invention. With reference to FIG. 7, reflecting surface 706 is inclined at an angle of 45 degrees with respect to the direction in which light rays 702 travel, depicted by an arrow 708. Light rays 702 are reflected from reflecting surface 706 towards a pre-defined view zone 710, as shown in FIG. 7.

In accordance with an embodiment of the present invention, the size, the shape and/or the location of a pre-defined view zone may be chosen suitably so as to maximize the amount of the reflected light rays transmitted towards the pre-defined view zone.

FIG. 7 is merely an example, which should not unduly limit the scope of the claims herein. One of ordinary skill in the art would recognize many variations, alternatives, and modifications of embodiments of the present invention. For example, reflecting surface 706 may be inclined at any suitable angle with respect to the direction in which light rays 702 travel.

In one embodiment of the present invention, a COB type device is manufactured by a COB process. As the COB process requires less space, an electronic substrate of a small size may be used. Consequently, the overall size of the COB type device may also be reduced. For example, the dimensions of the COB type device may be as follows: length ranging from 20 mm to 30 mm, width ranging from 10 mm to 15 mm, and height ranging from 1 mm to 2 mm. Such a small-sized COB type device is easy to carry and easy to use.

Consequently, the COB type device may be designed in several forms. In one example, the COB type device may be designed in the form of a small-sized chip that may be carried in a wallet. In another example, the COB type device may be designed in the form of a key ring that is easy to carry.

In case when the COB type device is a flash drive, the storage capacity of the COB type device may be increased without changing the overall dimensions of its casing.

Moreover, the cost of manufacture is reduced, as small-sized electronic substrates and bare semiconductor dies are used.

Embodiments of the present invention provide a casing suitable for enclosing an electronic device with a light source. The casing allows transmission of light emitted by the light source through a pre-defined view zone, while protecting the electronic device from external factors, such as heat, moisture and scratches. In this way, the casing allows a viewer to view the light from a comfortable position.

This application may disclose several numerical range limitations that support any range within the disclosed numerical ranges even though a precise range limitation is not stated verbatim in the specification because the embodiments of the invention could be practiced throughout the disclosed numerical ranges. Finally, the entire disclosure of the patents and publications referred in this application, if any, are hereby incorporated herein in entirety by reference.

Therefore, the foregoing is considered as illustrative only of the principles of the invention. Further, since numerous modifications and changes will readily occur to those skilled in the art, it is not desired to limit the invention to the exact construction and operation shown and described, and accordingly, all suitable modifications and equivalents may be resorted to, falling within the scope of the invention.

## Claims

1. A casing (102) for enclosing an electronic device (104), said electronic device (104) comprising one or more electrical components and a light source (106) placed on an electronic substrate, said light source (106) being located at a periphery associated with said electronic device (104), such that light emitted from said light source (106) travels in a direction parallel to a longitudinal axis (108) of said electronic device (104), said casing (102) comprising:
a first covering component (110), said first covering component (110) comprising one or more first portions at a first periphery associated with said first covering component (110); and
a second covering component (112), said second covering component (112) comprising:
one or more second portions at a second periphery associated with said second covering component (112), wherein said first portions and said second portions substantially complement each other, said first portions and said second portions are capable of being engaged together mechanically to enclose at least one section of said electronic device (104) in between said first covering component (110) and said second covering component (112), said at least one section comprising said light source (106); and
one or more reflecting surfaces (114) adapted to reflect light emitted from said light source (106) towards a pre-defined view zone (116), said pre-defined view zone (116) being a zone through which light reflected from said reflecting surfaces (114) is visible to a viewer, said reflecting surfaces (114) being inclined at one or more pre-defined angles with respect to said longitudinal axis (108) of said electronic device (104).

2. The casing of claim 1, wherein said pre-defined angles range from 15 degrees to 50 degrees.

3. The casing of claim 1, wherein said reflecting surfaces (114) are coated with a reflective material.

4. The casing of claim 1, wherein at least one of said first covering component (110) and said second covering component (112) comprises said pre-defined view zone (116), said pre-defined view zone (116) comprises at least one of: a hole, a transparent portion, and a translucent portion.

5. The casing of claim 1, wherein said electronic device (104) comprises one or more recessed portions at said periphery associated with said electronic device (104), and at least one of said first covering component (110) and said second covering component (112) comprises one or more protruding portions at an inner periphery, such that said recessed portions and said protruding portions substantially complement each other and engage together mechanically.

6. The casing of claim 1 is made of at least one material selected from the group consisting of acrylic, polyurethane, thermoplastic rubber, and plastic.

7. A flash drive comprising:
an electronic device (104) comprising:
an electronic substrate;
one or more electrical components placed on said electronic substrate;
a light source (106) placed on said electronic substrate, said light source (106) being located at a periphery associated with said electronic device (104);
one or more connectors for electrically connecting said electrical components and said light source (106) in a pre-defined manner; and
a molding material molded over a surface of said electronic substrate on which said electrical components and said light source (106) are placed, said molding material covers said light source (106) partially, such that light emitted from said light source (106) travels in a direction parallel to a longitudinal axis (108) of said electronic device (104); and
a casing (102) for enclosing at least one section of said electronic device (104), said at least one section comprising said light source (106), said casing (102) comprising:
a first covering component (110), said first covering component (110) comprising one or more first portions at a first periphery associated with said first covering component (110);
a second covering component (112), said second covering component (112) comprising:
one or more second portions at a second periphery associated with said second covering component (112), wherein said first portions and said second portions substantially complement each other, said first portions and said second portions are capable of being engaged together mechanically to enclose said at least one section of said electronic device (104) in between said first covering component (110) and said second covering component (112); and
one or more reflecting surfaces (114) adapted to reflect light emitted from said light source (106) towards a pre-defined view zone (116), said pre-defined view zone (116) being a zone through which light reflected from said reflecting surfaces (114) is visible to a viewer, said reflecting surfaces (114) being inclined at one or more pre-defined angles with respect to said longitudinal axis (108) of said electronic device (104).

8. The flash drive of claim 7, wherein said pre-defined angles range from 15 degrees to 50 degrees.

9. The flash drive of claim 7, wherein said reflecting surfaces (114) are coated with a reflective material.

10. The flash drive of claim 7, wherein at least one of said first covering component (110) and said second covering component (112) comprises said pre-defined view zone (116), said pre-defined view zone (116) comprises at least one of: a hole, a transparent portion, and a translucent portion.

11. The flash drive of claim 7, wherein said electronic device (104) comprises one or more recessed portions at said periphery associated with said electronic device (104), and at least one of said first covering component (110) and said second covering component (112) comprises one or more protruding portions at an inner periphery, such that said recessed portions and said protruding portions substantially complement each other and engage together mechanically.

12. The flash drive of claim 7, wherein said casing (102) is made of at least one material selected from the group consisting of acrylic, polyurethane, thermoplastic rubber, and plastic.

13. The flash drive of claim 7 is a Chip-On-Board (COB) type device.

14. The flash drive of claim 7 is a Surface Mount Technology (SMT) type device.
